# EUROPEAN PATENT APPLICATION

(11) **EP 4 660 651 A1**
(43) Date of publication of application: **10.12.2025**
(21) Application number: 24869766.6
(22) Date of filing: 22.05.2024
(51) Int. Cl.: G01R 31/392, G01R 31/367

(54) **BATTERY STATE OF HEALTH ASSESSMENT METHOD AND APPARATUS, VEHICLE, AND STORAGE MEDIUM**

(30) Priority: 25.09.2023 CN 202311250802
(71) Applicant: Chery Automobile Co., Ltd., Wuhu, Anhui 241006 (CN)
(72) Inventor: YANG, Yadong, Wuhu, Anhui 241006 (CN); HUANG, Bo, Wuhu, Anhui 241006 (CN); LU, Lei, Wuhu, Anhui 241006 (CN); LUO, Zhangxiang, Wuhu, Anhui 241006 (CN)
(74) Representative: Yang, Shu
(86) International application number: PCT/CN2024/094775
(87) International publication number: WO 2025/066200

(57) **Abstract**

A battery state of health assessment method and apparatus, a vehicle, and a storage medium. The method comprises: acquiring target working condition information of a target battery and a target cumulative charging and discharging capacity of the target battery under the target working condition, wherein the target working condition information comprises at least one of a battery temperature, a battery state of charge, and a charging mode (201); determining, from among battery health coefficients respectively corresponding to a plurality of working condition information intervals, a target battery health coefficient corresponding to the target working condition information, wherein the battery health coefficients are used for indicating the degrees of impact of different working condition information on the battery state of health (202); and determining the health degree of the target battery on the basis of the target cumulative charging and discharging capacity and the target battery health coefficient (203). A battery state of health assessment result is obtained by means of both the impact of different working conditions on the battery state of health and the cumulative charging and discharging capacities under different working conditions, so that the battery state of health assessment approach is more perfect, and the accuracy of battery state of health assessment is improved.

## Description

The present disclosure claims priority to Chinese Patent Application No. 202311250802.3, filed on September 25, 2023, and entitled "METHOD AND APPARATUS FOR EVALUATING STATE OF HEALTH OF BATTERY, VEHICLE, AND STORAGE MEDIUM", the disclosure of which is incorporated herein by reference in its entirety.

### TECHNICAL FIELD

The present disclosure relates to the field of battery technologies, and in particular, relates to a method and apparatus for evaluating state of health of a battery, a vehicle, and a storage medium.

### BACKGROUND

As one of the energy supply methods for new energy vehicles, batteries are widely used in the power field due to advantages such as low operating costs and minimal environmental pollution. To ensure the power supply performance of batteries and enhance the safety of the vehicle, it is usually necessary to evaluate the state of health of batteries to prevent the user's driving experience from being affected by battery aging and improve the safety of battery use.

In the related art, the state of health of a battery is usually evaluated by determining the cumulative charge-discharge capacity of the battery and taking the cumulative charge-discharge capacity as the health degree of the battery.

However, in the above-mentioned method, the evaluation method is too idealized and considers only a single influencing factor, which results in low accuracy of the evaluation results.

### SUMMARY

The present disclosure provides a method and apparatus for evaluating state of health of a battery, a vehicle, and a storage medium, which can improve the accuracy of the evaluation results for the state of health of a battery. The technical solutions are as follows:
In one aspect, a method for evaluating state of health of a battery is provided. The method includes:
acquiring target operating condition information of a target battery and a target cumulative charge-discharge capacity of the target battery under a target operating condition, wherein the target operating condition information includes at least one of battery temperature, battery state of charge, or charging mode, wherein the charging mode includes a fast charging mode and a slow charging mode;
determining a target battery health coefficient corresponding to the target operating condition information from battery health coefficients corresponding to a plurality of operating condition information intervals, wherein the battery health coefficient is configured to indicate a degree of influence of different operating condition information on state of health of a battery; and
determining a health degree of the target battery based on the target cumulative charge-discharge capacity and the target battery health coefficient, wherein the health degree is configured to indicate state of health of the target battery.

In some embodiments, the plurality of operating condition information intervals are operating condition information intervals corresponding to a target chemical system characteristic, and the target chemical system characteristic is a chemical system characteristic of the target battery, wherein operating condition information intervals corresponding to different chemical system characteristics are different.

In some embodiments, the chemical system characteristic includes at least one of the following: electrode material, electrolyte material, or electrode sheet process parameters.

In some embodiments, the battery health coefficients corresponding to the plurality of operating condition information intervals are obtained by simulating an entire life cycle of a battery;
wherein a simulation process includes:
acquiring a target temperature interval, a target state of charge interval, and a target charging mode, wherein the target temperature interval refers to a temperature interval causing battery life degradation, the target state of charge interval refers to a state of charge interval causing battery life degradation, and the target charging mode includes a plurality of charging modes;
dividing the target temperature interval into a plurality of temperature sub-intervals and dividing the target state of charge interval into a plurality of state of charge sub-intervals;
obtaining a plurality of operating condition information intervals by combining the plurality of temperature sub-intervals, the plurality of state of charge sub-intervals, and the plurality of charging modes, wherein each of the plurality of operating condition information intervals includes one temperature sub-interval, one state of charge sub-interval, and one charging mode;
determining, based on the plurality of operating condition information intervals and cumulative charge-discharge capacities respectively corresponding to the plurality of operating condition information intervals, the battery health coefficients respectively corresponding to the plurality of operating condition information intervals using a life-cycle simulation model.

In some embodiments, determining, based on the plurality of operating condition information intervals and cumulative charge-discharge capacities respectively corresponding to the plurality of operating condition information intervals, the battery health coefficients respectively corresponding to the plurality of operating condition information intervals using the life-cycle simulation model includes:
determining, for each of the plurality of operating condition information intervals, battery health coefficients respectively corresponding to multiple operating condition data in the operating condition information interval using the life-cycle simulation model, wherein each of the multiple operating condition data indicates one temperature, one state of charge, and one charging mode; and
determining, based on the battery health coefficients respectively corresponding to the multiple operating condition data and a cumulative charge-discharge capacity corresponding to the operating condition information interval, a battery health coefficient corresponding to the operating condition information interval.

In some embodiments, the target temperature interval, the target state of charge interval, and the target charging mode are respectively a temperature interval, a state of charge interval, and a charging mode corresponding to a target chemical system characteristic, wherein the target chemical system characteristic is a chemical system characteristic of the target battery, and temperature intervals, state of charge intervals, and charging modes corresponding to different chemical system characteristics are different.

In another aspect, an apparatus for evaluating state of health of a battery is provided. The apparatus includes:
a battery information acquisition module, configured to acquire target operating condition information of a target battery and a target cumulative charge-discharge capacity of the target battery under a target operating condition, wherein the target operating condition information includes at least one of battery temperature, battery state of charge, or charging mode, wherein the charging mode includes a fast charging mode and a slow charging mode;
a battery health coefficient determination module, configured to determine a target battery health coefficient corresponding to the target operating condition information from battery health coefficients corresponding to a plurality of operating condition information intervals, wherein the battery health coefficient is configured to indicate a degree of influence of different operating condition information on state of health of a battery; and
a battery health degree determination module, configured to determine a health degree of the target battery based on the target cumulative charge-discharge capacity and the target battery health coefficient, wherein the health degree is configured to indicate state of health of the target battery.

In some embodiments, the plurality of operating condition information intervals are operating condition information intervals corresponding to a target chemical system characteristic, and the target chemical system characteristic is a chemical system characteristic of the target battery, wherein operating condition information intervals corresponding to different chemical system characteristics are different.

In some embodiments, the chemical system characteristic includes at least one of the following: electrode material, electrolyte material, or electrode sheet process parameters.

In some embodiments, the battery health coefficients corresponding to the plurality of operating condition information intervals are obtained by simulating an entire life cycle of a battery;
wherein a simulation process includes:
acquiring a target temperature interval, a target state of charge interval, and a target charging mode, wherein the target temperature interval refers to a temperature interval causing battery life degradation, the target state of charge interval refers to a state of charge interval causing battery life degradation, and the target charging mode includes a plurality of charging modes;
dividing the target temperature interval into a plurality of temperature sub-intervals and dividing the target state of charge interval into a plurality of state of charge sub-intervals;
obtaining a plurality of operating condition information intervals by combining the plurality of temperature sub-intervals, the plurality of state of charge sub-intervals, and the plurality of charging modes, wherein each of the plurality of operating condition information intervals includes one temperature sub-interval, one state of charge sub-interval, and one charging mode;
determining, based on the plurality of operating condition information intervals and cumulative charge-discharge capacities respectively corresponding to the plurality of operating condition information intervals, the battery health coefficients respectively corresponding to the plurality of operating condition information intervals using a life-cycle simulation model.

In some embodiments, determining, based on the plurality of operating condition information intervals and cumulative charge-discharge capacities respectively corresponding to the plurality of operating condition information intervals, the battery health coefficients respectively corresponding to the plurality of operating condition information intervals using the life-cycle simulation model includes:
determining, for each of the plurality of operating condition information intervals, battery health coefficients respectively corresponding to multiple operating condition data in the operating condition information interval using the life-cycle simulation model, wherein each of the multiple operating condition data indicates one temperature, one state of charge, and one charging mode; and
determining, based on the battery health coefficients respectively corresponding to the multiple operating condition data and a cumulative charge-discharge capacity corresponding to the operating condition information interval, a battery health coefficient corresponding to the operating condition information interval.

In some embodiments, the target temperature interval, the target state of charge interval, and the target charging mode are respectively a temperature interval, a state of charge interval, and a charging mode corresponding to a target chemical system characteristic, wherein the target chemical system characteristic is a chemical system characteristic of the target battery, and temperature intervals, state of charge intervals, and charging modes corresponding to different chemical system characteristics are different.

In another aspect, a vehicle is provided. The vehicle includes a memory and a processor. The memory is configured to store at least one computer program, wherein the at least one computer program, when loaded and executed by the processor, causes the processor to perform the method for evaluating state of health of the battery as described above.

In another aspect, a computer-readable storage medium is provided. The storage medium stores at least one computer program, wherein the at least one computer program, when loaded and executed by a processor, causes the processor to perform the method for evaluating state of health of the battery as described above.

In another aspect, a computer program product including at least one instruction is provided. The at least one instruction, when loaded and executed on a computer, causes the computer to perform the method for evaluating state of health of the battery as described above.

The technical solution provided by the present disclosure can achieve at least the following beneficial effects:
Since the target operating condition information includes at least one of battery temperature, battery state of charge, or charging mode, all of which affect the state of health (SOH) of the battery, and different operating condition information has different degrees of influence on the SOH of the battery. Therefore, the evaluation of the SOH of the target battery is realized by determining the target battery health coefficient corresponding to the target operating condition information, and then determining the health degree of the target battery based on the target cumulative charge-discharge capacity and the target battery health coefficient. In other words, when evaluating the SOH of the target battery, the evaluation result of the SOH of the battery is comprehensively obtained by combining the influence of different operating conditions on the SOH of the battery and the cumulative charge-discharge capacity under different operating conditions, thereby improving the comprehensiveness of the battery SOH evaluation method and enhancing the accuracy of the battery SOH evaluation.

### BRIEF DESCRIPTION OF DRAWINGS

To describe the technical solutions in the embodiments of the present disclosure more clearly, the following briefly describes the accompanying drawings required for describing the embodiments. Apparently, the accompanying drawings in the following description show merely some embodiments of the present disclosure, and those of ordinary skill in the art may still derive other drawings from these accompanying drawings without creative efforts.
FIG. 1 is a schematic diagram of an implementation environment according to some embodiments of the present disclosure;
FIG. 2 is a flowchart for a method for evaluating state of health of a battery according to some embodiments of the present disclosure;
FIG. 3 is a schematic structural diagram of an apparatus for evaluating state of health of a battery according to some embodiments of the present disclosure;
FIG. 4 is a schematic structural diagram of a computer device according to some embodiments of the present disclosure; and
FIG. 5 is a schematic structural diagram of a vehicle according to some embodiments of the present disclosure.

### DETAILED DESCRIPTION

In order to make the objectives, technical solutions, and advantages of embodiments of the present disclosure clearer, the embodiments of the present disclosure will be described in further detail below with reference to the accompanying drawings.

Before providing a detailed explanation of a method for evaluating state of health of a battery according to the embodiments of the present disclosure, the application scenarios and implementation environments involved in the embodiments of the present disclosure will first be introduced.

The embodiments of the present disclosure are primarily applied to scenarios where evaluating the state of health of a vehicle battery is required. The evaluation scenarios may be closed test scenarios, such as a test bench for vehicle batteries. The evaluation scenarios may be open usage scenarios, such as scenarios where the state of health of a battery is evaluated under the daily operating environment of the battery.

It should be noted that, as the core energy supply of a new energy vehicle, the performance state of batteries directly affects the user experience of the new energy vehicle. During the daily use of batteries, the charging and discharging process of the battery can be understood as a process in which ions (such as lithium ions) inside the battery migrate repeatedly between the positive and negative electrodes. With the increase in battery usage time, the long-term cyclic movement of ions leads to the gradual consumption of some ions as the active material ages; even some ions lose their ability to move freely between the positive and negative electrodes due to reduced activity. As a result, after long-term charging and discharging cycles, the dischargeable capacity of the battery decreases, and aging occurs.

Therefore, accurately determining the state of health of a battery in real time not only enables timely reminders to users for battery maintenance or replacement when aging occurs, but also allows real-time correction of to the state of power (SOP) related to the battery's external discharge power and the state of charge (SOC) related to the estimation of driving range based on the SOH of the battery, thereby improving the calculation accuracy of SOP and SOC.

Furthermore, from another perspective, accurately determining the state of health of a battery in real time and promptly reminding users to maintain or replace the battery not only ensures the power supply efficiency of the battery and guarantees the user experience, but also prevents the misuse of aged batteries, thereby enhancing the safety of both the battery and the vehicle.

In related art, the state of health (SOH) of the battery can be determined by methods, such as accumulating the charge-discharge capacity of the battery or calculating calendar life, to characterize the aging and degradation of the battery, i.e., state of health. However, these methods consider only a single factor and yield overly idealized calculation results. For example, the daily operating scenarios of batteries are relatively complex, and different operating conditions (e.g., different battery temperatures, different battery charge states, and different battery charging modes) have significantly different impacts on battery capacity degradation. Therefore, the SOH of the battery obtained by the above methods cannot accurately reflect the current SOH of the battery.

Based on this, the embodiments of the present disclosure provide a method for evaluating the SOH of a battery. By fully considering the complex scenarios during the use of the battery and combining the impacts of different operating conditions on the SOH of the battery with the cumulative charge-discharge capacity under different operating conditions, a comprehensive evaluation result of the SOH of the battery is obtained. This improves the comprehensiveness of the battery SOH evaluation method and enhances the accuracy of the battery SOH evaluation.

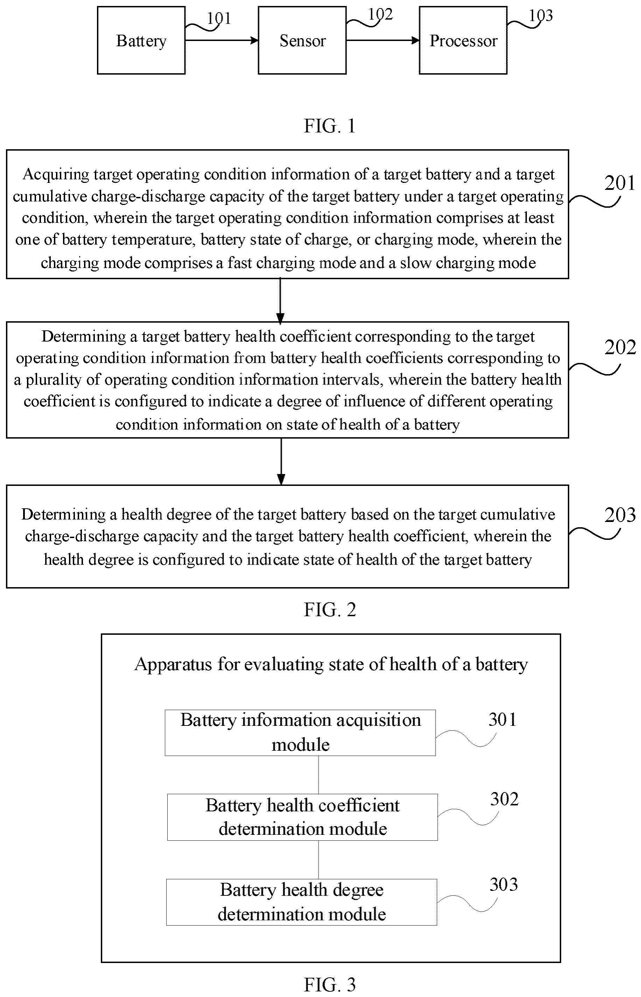

Referring to FIG. 1, FIG. 1 is a schematic diagram of an implementation environment according to some embodiments of the present disclosure. The implementation environment includes at least one battery 101, a sensor 102, and a processor 103. The sensor 102 can be communicatively connected with at least one battery 101 and the processor 103, respectively. The communication connection may be a wired or wireless connection, which is not limited in the embodiments of the present disclosure.

In some embodiments, the battery 101, the sensor 102, and the processor 103 may be provided independently or integrated into the same device (e.g., integrated into the same vehicle).

The battery 101 may include a plurality of battery packs to provide electrical power to the vehicle.

The sensor 102 is used to detect the operating condition information of the battery 101. For example, the sensor 102 may include a temperature sensor for detecting the battery temperature of the battery 101; the sensor 102 may also include a SOC sensor for determining the SOC of the battery 101; the sensor 102 may further include a voltage-current sensor for determining the voltage and current during the battery 101 charging. The voltage and current are used to determine the charging mode of the battery and/or the cumulative charge-discharge capacity of the battery. The cumulative charge-discharge capacity may also be understood as the cumulative charge-discharge electrical capacity (ampere-hours, AH) of the battery.

In some embodiments, the sensor 102 and the battery 101 may be integrated to form the battery system of the vehicle, and the processor 103 obtains the operating condition information of the battery 101 through the sensor 102 in the battery system.

The processor 103 is used to obtain the operating condition information of the battery through the sensor 102, and based on the operating condition information, determine the battery health coefficient corresponding to the operating condition information. For example, the processor 103 stores a plurality of correspondences between operating condition information intervals and battery health coefficients, and then determines the battery health coefficient corresponding to the operating condition information of the battery 101 based on the operating condition information.

For example, the processor 103 may determine the operating condition information interval to which the operating condition information belongs based on the operating condition information of the battery, and determine the battery health coefficient corresponding to the operating condition information interval as the battery health coefficient corresponding to the operating condition information.

After determining the battery health coefficient corresponding to the operating condition information, the processor 103 may determine the health degree of the battery based on the battery health coefficient corresponding to the operating condition information and the cumulative charge-discharge capacity under the operating condition corresponding to the operating condition information.

In some embodiments, after determining the health degree of the battery 101, the processor 103 may also report the currently determined health degree of the battery to the control system of the vehicle in real time.

The execution entity of the method for evaluating state of health of the battery according to the embodiments of the present disclosure is the above-mentioned processor 103. The processor 103 may be a general-purpose central processing unit (CPU), a network processor (NP), a microprocessor, or one or more integrated circuits for implementing the scheme of the present disclosure, such as an application-specific integrated circuit (ASIC), a programmable logic device (PLD), or a combination thereof. The above-mentioned PLD may be a complex programmable logic device (CPLD), a field-programmable gate array (FPGA), a generic array logic (GAL), or any combination thereof.

Those skilled in the art will understand that the processor 103 described above is merely an example. Other existing or future processors that may be applicable to the embodiments of the present disclosure should also be included within the scope of protection of the embodiments of the present disclosure and are hereby incorporated by reference.

It should be noted that the application scenarios and implementation environments described in the embodiments of the present disclosure are provided to illustrate the technical solutions of the embodiments of the present disclosure more clearly and do not constitute limitations on the technical solutions provided by the embodiments of the present disclosure. Those skilled in the art will understand that as new application scenarios emerge and implementation environments evolve, the technical solutions provided by the embodiments of the present disclosure are equally applicable to similar technical problems.

The following provides a detailed explanation of the method for evaluating state of health of the battery according to the embodiments of the present disclosure.

FIG. 2 is a flowchart for a method for evaluating state of health of a battery according to some embodiments of the present disclosure. The method is applied to the above-mentioned processor. Referring to FIG. 2, the method includes the following steps.

In step 201, target operating condition information of a target battery and a target cumulative charge-discharge capacity of the target battery under a target operating condition are acquired, wherein the target operating condition information includes at least one of battery temperature, battery state of charge, or charging mode, wherein the charging mode includes a fast charging mode and a slow charging mode.

In some embodiments, the sensor may obtain the target operating condition information of the battery and the target cumulative charge-discharge capacity of the battery under the target operating condition, and then transmit the target operating condition information and the target cumulative charge-discharge capacity to the processor. The target operating condition refers to the operating condition indicated by the target operating condition information.

The fast charging mode may refer to a charging mode where the charging voltage, current, and/or power is greater than or equal to a predetermined threshold, and the slow charging mode may refer to a charging mode where the charging voltage, current, and/or power is less than the predetermined threshold; or, the fast charging mode and the slow charging mode may also refer to the fast charging mode and slow charging mode of the battery as defined in relevant industry standards, which are not limited in the embodiments of the present disclosure. The predetermined threshold may be determined based on experimental data or relevant protocol specifications.

For example, the fast charging mode refers to a charging mode where the charging power is greater than or equal to 40 kilowatts (kW), and the slow charging mode refers to a charging mode where the charging power is less than 40 kW.

In step 202, a target battery health coefficient corresponding to the target operating condition information is determined from the battery health coefficients corresponding to a plurality of operating condition information intervals, wherein the battery health coefficient is configured to indicate a degree of influence of different operating condition information on state of health of a battery.

In the embodiments of the present disclosure, one operating condition information interval corresponds to one battery health coefficient, and different operating condition information intervals correspond to different battery health coefficients. Based on this, the operating condition information interval to which the target operating condition information belongs can be determined from the plurality of operating condition information intervals, and the battery health coefficient corresponding to the operating condition information interval in which the target operating condition information is located can be determined as the target battery health coefficient corresponding to the target operating condition information.

In some embodiments, the plurality of operating condition information intervals may be operating condition information intervals corresponding to a target chemical system characteristic, and the target chemical system characteristic is a chemical system characteristic of the target battery, wherein operating condition information intervals corresponding to different chemical system characteristics are different.

It should be noted that due to differences in battery service life and the sensitivity of batteries to changes in operating condition information under different chemical system characteristics, the operating condition information intervals corresponding to batteries with different chemical system characteristics may also differ. Taking the battery temperature interval as an example, batteries with different chemical system characteristics exhibit differences in their sensitivity to changes in battery temperature, and thus, the battery temperature intervals corresponding to batteries under different chemical system characteristics will also vary.

For example, batteries with chemical system characteristic A are high-temperature-resistant batteries developed based on actual application requirements, having weak sensitivity to high temperatures. That is, these batteries can still maintain relatively stable operating performance and safety under high-temperature conditions. Therefore, the corresponding battery temperature interval for these batteries may be [-30°C, 80°C]. Batteries with chemical system characteristic B are low-temperature-resistant batteries developed based on actual application requirements, having weak sensitivity to low temperatures. That is, these batteries can still maintain relatively stable operating performance and safety under low-temperature conditions. Therefore, the corresponding battery temperature interval for these batteries may be [-60°C, 40°C].

It should be understood that after the vehicle is assembled and manufactured, the chemical system characteristic of the battery equipped in the vehicle is already determined, and thus, the operating condition information intervals corresponding to the battery are also determined.

In some embodiments, the chemical system characteristic may include at least one of the following: electrode material, electrolyte material, and electrode sheet process parameters.

It should be noted that the electrode material refers to the positive and negative electrode materials of the battery, such as lithium alloy metal oxides for the positive electrode and graphite materials for the negative electrode. The electrolyte material refers to the medium used in the battery to provide the necessary ions for normal operation, such as organic solvents or potassium salt electrolytes. The electrode sheet process parameters refer to the relevant process parameters during the production of electrode sheets, such as electrochemical processes, slurry composition, and mixing process requirements.

In some embodiments, the battery health coefficients corresponding to the plurality of operating condition information intervals may be embedded in the processor by other electronic devices after simulating the entire life cycle of the battery, or may be obtained by the aforementioned processor after simulating the entire life cycle of the battery. The simulation process may include the following steps (1) to (4). That is, the entire life cycle of the battery can be simulated through the following steps (1) to (4) to obtain the battery health coefficients corresponding to the plurality of operating condition information intervals.
(1) The target temperature interval, the target state of charge interval, and the target charging mode are acquired, wherein the target temperature interval refers to a temperature interval causing battery life degradation, the target state of charge interval refers to a state of charge interval causing battery life degradation, and the target charging mode includes a plurality of charging modes.

The target charging mode may be understood as the charging current interval that causes battery life degradation. The battery life degradation refers to the loss of battery functionality and actual capacity during battery use due to the sensitivity of the battery cell to changes in temperature, SOC, and current.

In some embodiments, the target temperature interval, the target state of charge interval, and the target charging mode are respectively a temperature interval, a state of charge interval, and a charging mode corresponding to a target chemical system characteristic, wherein the target chemical system characteristic is a chemical system characteristic of the target battery, and temperature intervals, state of charge intervals, and charging modes corresponding to different chemical system characteristics are different.

Since the temperature intervals, the state of charge intervals, and the charging modes corresponding to different chemical system characteristics are different, it is possible to pre-establish a correspondence table between chemical system characteristics and temperature intervals, state of charge intervals, and charging modes. The temperature intervals, the state of charge intervals, and the charging modes corresponding to the target chemical system characteristic can be acquired from the correspondence table, and can be determined as the target temperature interval, the target state of charge interval, and the target charging mode.

For example, based on a test bench for a vehicle battery, the entire life cycles of batteries with different chemical system characteristics can be simulated to determine the temperature intervals, the state of charge intervals, and the charging modes that cause life degradation of batteries with different chemical system characteristics, thereby obtaining a correspondence table between the chemical system characteristics of the battery and the temperature intervals, the state of charge intervals, and the charging modes.

(2) The target temperature interval is divided into a plurality of temperature sub-intervals, and the target state of charge interval is divided into a plurality of state of charge sub-intervals.

In some embodiments, the target temperature interval may be divided into a plurality of temperature sub-intervals according to a temperature division strategy, and the target state of charge interval may be divided into the plurality of state of charge sub-intervals according to a state of charge division strategy.

The temperature division strategy and the state of charge division strategy may be the same or different. In practice, the temperature division strategy and the state of charge division strategy may also be adjusted according to actual needs.

It can be understood that when the temperature intervals and state of charge intervals corresponding to different chemical system characteristics are different, the number and interval boundaries of temperature sub-intervals and the number and interval boundaries of state of charge sub-intervals, corresponding to different chemical system characteristics may also differ. Furthermore, the temperature division strategy and state of charge division strategy corresponding to different chemical system characteristics may be determined according to requirements, which are not limited in the embodiments of the present disclosure.

For example, assuming the target temperature interval is [-30°C, 80°C], since Battery A has different sensitivities to different temperatures, the life degradation of Battery A caused under different temperatures also differs. For example, Battery A is a battery with weak sensitivity to high temperatures, which can still maintain relatively stable operating performance and safety under high-temperature conditions. Based on this, the target temperature interval for Battery A can be divided based on its temperature sensitivity, resulting in three temperature sub-intervals: [-30°C, 0°C), [0°C, 25°C), and [25°C, 80°C].

(3) The plurality of operating condition information intervals are obtained by combining the plurality of temperature sub-intervals, the plurality of state of charge sub-intervals, and the plurality of charging modes, wherein each of the plurality of operating condition information intervals includes one temperature sub-interval, one state of charge sub-interval, and one charging mode.

For example, the plurality of temperature sub-intervals are [-30°C, 0°C), [0°C, 25°C), and [25°C, 80°C]; the plurality of state of charge sub-intervals are [0, 25%), [25%, 75%), and [75%, 100%], and the plurality of charging modes are fast charging mode and slow charging mode. By combining these three temperature sub-intervals, three state of charge sub-intervals, and two charging modes, 18 operating condition information intervals are obtained, each of which includes one temperature sub-interval, one state of charge sub-interval, and one charging mode. For example, one of the operating condition information intervals is an operating condition information interval with a temperature sub-interval of [-30°C, 0°C), a state of charge sub-interval of [25%, 75%), and a charging mode of slow charging mode.

(4) Based on the plurality of operating condition information intervals and cumulative charge-discharge capacities respectively corresponding to the plurality of operating condition information intervals, the battery health coefficients respectively corresponding to the plurality of operating condition information intervals are determined using a life-cycle simulation model.

In some embodiments, the life cycles of the battery under different operating condition information intervals can be simulated based on a life-cycle simulation model, such that the battery health coefficients respectively corresponding to the plurality of operating condition information intervals can be determined based on the life cycles of the battery under the different operating condition information intervals.

Since the principle for determining the battery health coefficient corresponding to each of the plurality of operating condition information intervals is the same, the following description will use one of the operating condition information intervals as an example.

In some embodiments, for any one of the plurality of operating condition information intervals, the battery health coefficients respectively corresponding to multiple operating condition data in the operating condition information interval are determined using the life-cycle simulation model. Each of the multiple operating condition data indicates one temperature, one state of charge, and one charging mode. Based on the battery health coefficients respectively corresponding to the multiple operating condition data and the cumulative charge-discharge capacity corresponding to the operating condition information interval, the battery health coefficient corresponding to the operating condition information interval is determined.

As an example, the operating condition information interval includes multiple operating condition data, and the cumulative charge-discharge capacity corresponding to the operating condition information interval includes the cumulative charge-discharge capacities corresponding to the multiple operating condition data. In this case, the operating condition information interval is input into the life-cycle simulation model to obtain the health degrees of the battery respectively corresponding to the multiple operating condition data output by the life-cycle simulation model. Based on the health degree of the battery corresponding to each operating condition data and the cumulative charge-discharge capacity corresponding to each operating condition data, the battery health coefficient corresponding to each operating condition data is determined. Based on the battery health coefficients respectively corresponding to the multiple operating condition data, the battery health coefficient corresponding to the operating condition information interval is determined.

In some embodiments, for any operating condition data in the operating condition information interval, the health degree of the battery corresponding to the operating condition data is divided by the cumulative charge-discharge capacity corresponding to the operating condition data to obtain the battery health coefficient corresponding to the operating condition data. Then, the average of the battery health coefficients corresponding to the multiple operating condition data in the operating condition information interval is determined as the battery health coefficient corresponding to the operating condition information interval.

In some embodiments, the electronic device or the processor performing the simulation process may include a plurality of databases for storing cumulative ampere-hour data, also referred to as cumulative ampere-hour databases. Different operating condition information intervals correspond to different cumulative amp-hour databases, and different cumulative amp-hour databases are used to store the cumulative charge-discharge capacity (also referred to as cumulative charge-discharge amp-hours or cumulative charge-discharge amp-hour counts) corresponding to each operating condition data in the respective operating condition information intervals. Therefore, for each of the plurality of operating condition information intervals, the cumulative charge-discharge capacity corresponding to each operating condition data in the operating condition information interval can be obtained from the cumulative ampere-hour database corresponding to the operating condition information interval. Based on the cumulative charge-discharge capacity corresponding to each operating condition data, the battery health coefficient corresponding to the operating condition information interval can be determined.

Furthermore, considering that individual operating condition data may be subject to randomness, to prevent random data from affecting the accuracy of the battery health coefficient, for any operating condition information interval, a plurality of battery health coefficients can be determined respectively based on the multiple operating condition data in the operating condition information interval, and then the battery health coefficient corresponding to the operating condition information interval can be obtained comprehensively based on the plurality of battery health coefficients. This avoids the problem of excessive random errors caused by individual operating condition data, thereby improving the accuracy of the battery health coefficient corresponding to each operating condition information interval.

In some embodiments, the life-cycle simulation model can be constructed based on the chemical system characteristic of the battery, with different chemical system characteristics corresponding to different life-cycle simulation models. Based on this, in a case of determining the battery health coefficients for the plurality of operating condition information intervals corresponding to the target chemical system characteristic, the life-cycle simulation model corresponding to the target chemical system characteristic can be determined, and then the battery health coefficients for the plurality of operating condition information intervals corresponding to the target chemical system characteristic can be determined using the life-cycle simulation model corresponding to the target chemical system characteristic.

For example, a lithium iron phosphate (LiFePO4) battery was developed for the high-temperature market, and a life-cycle simulation model was constructed based on the chemical system characteristic of the battery. The temperature interval of the battery is divided into three temperature sub-intervals: [10°C, 25°C), [25°C, 35°C), and [35°C, 60°C]; the state of charge interval is divided into three state of charge sub-intervals: [5%, 30%), [30%, 80%), and [80%, 100%]; and the charging modes are divided into the fast charging mode and the slow charging mode. By combining the three temperature sub-intervals, three state of charge sub-intervals, and two charging modes, 18 operating condition information intervals are obtained. Then, based on the operating condition data in each operating condition information interval and the cumulative charge-discharge capacity corresponding to each operating condition data, the battery health coefficient corresponding to each operating condition information interval is determined using the life-cycle simulation model corresponding to the battery, that is, µ1 to µ18.

It should be noted that the simulation process provided in the embodiments of the present disclosure can also be applied to scenarios involving comparative analysis of battery health coefficients under different operating conditions.

For example, a battery system S1 is developed for low-temperature regions. The chemical system characteristic of the battery system S1 is designed to consider the impact of low-temperature environments, such as temperatures below 0°C, on battery life. In other words, the battery system S1 is a low-temperature-resistant battery system. A life-cycle simulation model 1 is constructed based on the chemical system characteristic of battery system S1. A battery system S2 developed for normal temperature environments is selected, i.e., the battery system S2 is a battery system that is not low-temperature resistant. A life-cycle simulation model 2 is constructed based on the chemical system characteristic of the battery system S2. Assuming that a certain operating condition information interval is -20°C < T < 0°C and 30% ≤ SOC ≤ 80%, the battery health coefficient µ1 corresponding to the battery system S1 in the operating condition information interval is determined using the life-cycle simulation model 1. Similarly, the battery health coefficient µ2 corresponding to the battery system S2 in the operating condition information interval is determined using the life-cycle simulation model 2. The simulation results show that µ1 < µ2.

For another example, a battery system is charged using different charging modes. The fast charging mode uses a step current based on the fast-charging power map, and the slow charging mode uses a rated output power of 6.6 kW. A life-cycle simulation model is constructed based on the chemical characteristic of the battery. Assuming there are currently two operating condition information intervals, both of which include temperature sub-intervals of 20°C < T < 25°C, state of charge sub-intervals of 30% ≤ SOC ≤ 80%, and charging modes of fast charging mode and slow charging mode. Using this life-cycle simulation model. The battery health coefficients corresponding to these two operating condition information intervals are determined, i.e., the battery health coefficient µ_{slow-charging} corresponding to the fast charging mode and the battery health coefficient µ_{fast-charging} corresponding to the slow charging mode. Comparing the results shows that µ_{slow-charging} < µ_{fast-charging}.

Step 203: A health degree of the target battery is determined based on the target cumulative charge-discharge capacity and the target battery health coefficient, wherein the health degree is configured to indicate the state of health of the target battery.

In some embodiments, the target cumulative charge-discharge capacity can be multiplied by the target battery health coefficient to obtain the health degree of the target battery.

It should be noted that in different scenarios, the method for determining the health degree of the target battery based on the target cumulative charge-discharge capacity and the target battery health coefficient may also vary. For example, in other embodiments, the numerical range of the health degree of the battery is 0-100%. The battery degradation value can be determined based on the target cumulative charge-discharge capacity and the target battery health coefficient, and the difference between 1 and the battery degradation value is then determined as the health degree of the target battery.

For example, if the target cumulative charge-discharge capacity is r1 and the target battery health coefficient is µ2, then the health degree of the target battery SOH = 1 - r1 * µ2.

In addition, considering that operating conditions may change during battery use, and that battery health degradation is continuously accumulated under different operating conditions. In some embodiments, the cumulative charge-discharge capacity under each operating condition during battery use can also be determined. Based on the cumulative charge-discharge capacity under each operating condition and the battery health coefficient corresponding to each operating condition, the health degree of the target battery is determined.

For example, the usage scenarios of the target battery after leaving the factory involve six operating condition information intervals, namely q1-q6, with the cumulative charge-discharge capacities corresponding to the operating condition information intervals being r1-r6, and the battery health coefficients corresponding to the operating condition information intervals being µ1-µ6. If the cumulative charge-discharge capacity of the target battery under operating condition interval q5 is r5, and the battery health coefficient corresponding to operating condition interval q5 is µ5, then the health degree of the target battery SOH is calculated as SOH = 1 - (r1 * µ1 + r2 * µ2 + r3 * µ3 + r4 * µ4 + r5 * µ5 + r6 * µ6).

It should be noted that as the operating environment of the target battery (such as vehicle driving time, location, and weather) changes, the operating condition of the target battery will also change. Therefore, in practice, the battery health degree of the target battery at different times can be determined, enabling users to promptly monitor the SOH of the target battery.

The present disclosure proposes a method for evaluating state of health of a battery, considering that under different chemical system characteristics, the sensitivity of battery life degradation to changes in temperature, state of charge, and charging mode varies, to ensure that the battery health coefficient of the target battery better aligns with the sensitivity of the target battery to operating condition changes, a plurality of operating condition information intervals of the target battery are determined based on the chemical system characteristics of the target battery. Further, through simulating the battery lifecycle using a life-cycle simulation model, the battery health coefficients corresponding to different operating condition information intervals are obtained, enabling the battery health coefficients to fully consider the impact of different operating conditions on the SOH of the battery and thereby enhance the accuracy of the battery health coefficients. Furthermore, when the target operating condition information of the target battery is obtained, the health degree of the target battery can be determined based on the target battery health coefficient corresponding to the target operating condition information and the target cumulative charge-discharge capacity of the target battery under the target operating condition, thereby realizing the evaluation of the SOH of the target battery. In other words, in a case of evaluating the SOH of the target battery, changes in complex operating conditions during the actual use of the battery are comprehensively considered, such as the impact of changes in factors like battery chemical system characteristics, battery temperature, battery state of charge, and battery charge-discharge current (charging mode) on the magnitude of battery life degradation. Different battery health coefficients corresponding to different operating condition intervals are introduced, and the evaluation result of the SOH of the battery is comprehensively obtained by combining the impact of different operating conditions on the SOH of the battery and the cumulative charge-discharge capacity under different operating conditions, thereby improving the accuracy of the battery SOH evaluation.

FIG. 3 is a schematic structural diagram of an apparatus for evaluating the state of health of a battery according to some embodiments of the present disclosure. The apparatus for evaluating the state of health of the battery can be implemented by software, hardware, or a combination thereof to form part or all of the apparatus for evaluating the state of health of the battery. The apparatus for evaluating the state of health of the battery may be a processor or a computer device involved in the implementation environment shown in FIG. 1. Referring to FIG. 3, the apparatus includes a battery information acquisition module 301, a battery health coefficient determination module 302, and a battery health degree determination module 303.

The battery information acquisition module 301 is configured to acquire target operating condition information of a target battery and a target cumulative charge-discharge capacity of the target battery under a target operating condition, wherein the target operating condition information includes at least one of battery temperature, battery state of charge, or charging mode, wherein the charging mode includes a fast charging mode and a slow charging mode.

The battery health coefficient determination module 302 is configured to determine a target battery health coefficient corresponding to the target operating condition information from battery health coefficients corresponding to a plurality of operating condition information intervals, wherein the battery health coefficient is configured to indicate a degree of influence of different operating condition information on the state of health of a battery.

The battery health degree determination module 303 is configured to determine a health degree of the target battery based on the target cumulative charge-discharge capacity and the target battery health coefficient, wherein the health degree is configured to indicate the state of health of the target battery.

In some embodiments, the plurality of operating condition information intervals are operating condition information intervals corresponding to a target chemical system characteristic, and the target chemical system characteristic is a chemical system characteristic of the target battery, wherein operating condition information intervals corresponding to different chemical system characteristics are different.

In some embodiments, the chemical system characteristic includes at least one of the following: electrode material, electrolyte material, and electrode sheet process parameters.

In some embodiments, the battery health coefficients corresponding to the plurality of operating condition information intervals are obtained by simulating an entire life cycle of the battery;
wherein the simulation process includes:
acquiring a target temperature interval, a target state of charge interval, and a target charging mode, wherein the target temperature interval refers to a temperature interval causing battery life degradation, the target state of charge interval refers to a state of charge interval causing battery life degradation, and the target charging mode includes a plurality of charging modes;
dividing the target temperature interval into a plurality of temperature sub-intervals and dividing the target state of charge interval into a plurality of state of charge sub-intervals;
obtaining a plurality of operating condition information intervals by combining the plurality of temperature sub-intervals, the plurality of state of charge sub-intervals, and the plurality of charging modes, wherein each of the plurality of operating condition information intervals includes one temperature sub-interval, one state of charge sub-interval, and one charging mode;
determining, based on the plurality of operating condition information intervals and cumulative charge-discharge capacities respectively corresponding to the plurality of operating condition information intervals, the battery health coefficients respectively corresponding to the plurality of operating condition information intervals using a life-cycle simulation model.

In some embodiments, determining, based on the plurality of operating condition information intervals and cumulative charge-discharge capacities respectively corresponding to the plurality of operating condition information intervals, the battery health coefficients respectively corresponding to the plurality of operating condition information intervals using the life-cycle simulation model includes:
determining, for each of the plurality of operating condition information intervals, battery health coefficients respectively corresponding to multiple operating condition data in the operating condition information interval using the life-cycle simulation model, wherein each of the multiple operating condition data indicates one temperature, one state of charge, and one charging mode; and
determining, based on the battery health coefficients respectively corresponding to the multiple operating condition data and a cumulative charge-discharge capacity corresponding to the operating condition information interval, a battery health coefficient corresponding to the operating condition information interval.

In some embodiments, the target temperature interval, the target state of charge interval, and the target charging mode are respectively a temperature interval, a state of charge interval, and a charging mode corresponding to a target chemical system characteristic, wherein the target chemical system characteristic is a chemical system characteristic of the target battery, and temperature intervals, state of charge intervals, and charging modes corresponding to different chemical system characteristics are different.

In the embodiments of the present disclosure, considering that under different chemical system characteristics, the sensitivity of battery life degradation to changes in temperature, state of charge, and charging mode varies, to ensure that the battery health coefficient of the target battery better aligns with the sensitivity of the target battery to operating condition changes, a plurality of operating condition information intervals of the target battery are determined based on the chemical system characteristics of the target battery. Further, through simulating the battery lifecycle using a life-cycle simulation model, the battery health coefficients corresponding to different operating condition information intervals are obtained, enabling the battery health coefficients to fully consider the impact of different operating conditions on the SOH of the battery and thereby enhance the accuracy of the battery health coefficients. Furthermore, when the target operating condition information of the target battery is obtained, the health degree of the target battery can be determined based on the target battery health coefficient corresponding to the target operating condition information and the target cumulative charge-discharge capacity of the target battery under the target operating condition, thereby realizing the evaluation of the SOH of the target battery. In other words, in a case of evaluating the SOH of the target battery, changes in complex operating conditions during the actual use of the battery are comprehensively considered, such as the impact of changes in factors like battery chemical system characteristics, battery temperature, battery state of charge, and battery charge-discharge current (charging mode) on the magnitude of battery life degradation. Different battery health coefficients corresponding to different operating condition intervals are introduced, and the evaluation result of the SOH of the battery is comprehensively obtained by combining the impact of different operating conditions on the SOH of the battery and the cumulative charge-discharge capacity under different operating conditions, thereby improving the accuracy of the battery SOH evaluation.

It should be noted that the apparatus for evaluating the state of health of the battery provided in the above examples is illustrated using the division of the aforementioned functional modules for the purpose of evaluating the state of health of the battery. In practice, the aforementioned functions can be distributed among different functional modules as needed, i.e., the internal structure of the device can be divided into different functional modules to perform all or part of the functions described above. In addition, the battery health assessment device and the battery health assessment method provided in the above examples belong to the same concept, and their specific implementation processes are detailed in the method examples, so they will not be repeated here.

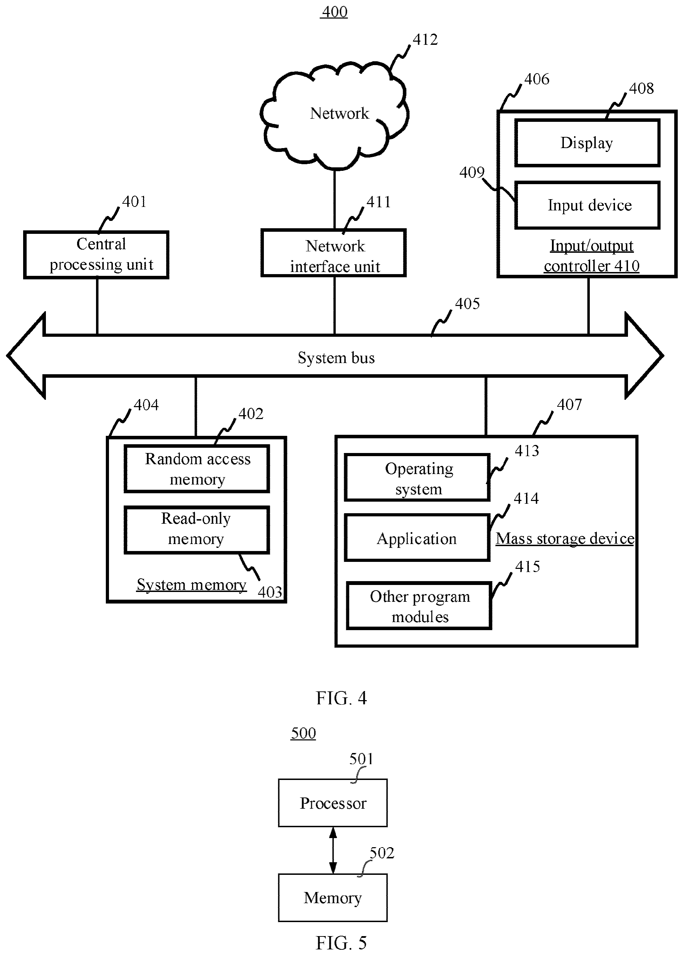

FIG. 4 is a schematic structural diagram of a computer device according to some embodiments of the present disclosure. The computer device 400 includes a central processing unit (CPU) 401, a system memory 404 including a random access memory (RAM) 402 and a read-only memory (ROM) 403, and a system bus 405 connecting the system memory 404 and the central processing unit 401. The computer device 400 further includes a basic input/output system (I/O system) 406 for facilitating information transmission between various components in the computer, and a mass storage device 407 for storing an operating system 413, an application 414, and other program modules 415.

The basic input/output system 406 includes a display 408 for displaying information and an input device 409, such as a mouse or a keyboard, for user input. Both the display 408 and the input device 409 are connected to the central processing unit 401 via an input/output controller 410 connected to the system bus 405. The basic input/output system 406 may also include an input/output controller 410 for receiving and processing input from multiple other devices, such as a keyboard, a mouse, or an electronic stylus. Similarly, the input/output controller 410 also provides output to displays, printers, or other types of output devices.

The mass storage device 407 is connected to the central processing unit 401 via a mass storage controller (not shown) connected to the system bus 405. The mass storage device 407 and its associated computer-readable media provide non-volatile storage for the computer device 400. That is, the mass storage device 407 may include computer-readable media such as a hard disk or CD-ROM drive (not shown).

Without limiting the generality, the computer-readable media may include computer storage media and communication media. The computer storage media include volatile and non-volatile, removable and non-removable media implemented in any method or technology for storing information such as computer-readable instructions, data structures, program modules, or other data. The computer storage media include RAM, ROM, EPROM, EEPROM, flash memory, or other solid-state storage technologies, CD-ROM, DVD, or other optical storage, tape cartridges, tapes, disk storage, or other magnetic storage devices. In addition, those skilled in the art will recognize that the computer storage media are not limited to the above examples. The system memory 404 and the mass storage device 407 may collectively be referred to as a memory.

According to various embodiments of the present disclosure, the computer device 400 may also be connected to a remote computer system over a network such as the Internet. That is, the computer device 400 may be connected to the network 412 via a network interface unit 411 connected to the system bus 405, or the network interface unit 411 may be used to connect to other types of networks or remote computer systems (not shown).

The aforementioned memory further includes one or more programs, with one or more programs stored in the memory and configured to be executed by the CPU.

FIG. 5 is a schematic structural diagram of a vehicle according to some embodiments of the present disclosure. Typically, the vehicle 500 includes a processor 501 and a memory 502.

The processor 501 may include one or more processing cores, such as a 4-core processor, an 8-core processor, etc. The processor 501 may be implemented using at least one of the following hardware forms: digital signal processing (DSP), field programmable gate array (FPGA), or programmable logic array (PLA). The processor 501 may also include a main processor and a coprocessor. The main processor is a processor used to process data in the wake-up state, also known as a central processing unit (CPU); the coprocessor is a low-power processor used to process data in the standby state. In some embodiments, the processor 501 may include a graphics processing unit (GPU) integrated therein, with the GPU responsible for rendering and drawing the content to be displayed on the display screen. In some embodiments, the processor 501 may also include an artificial intelligence (AI) processor, which is used to perform computational operations related to machine learning.

The memory 502 may include one or more computer-readable storage media, which may be non-transitory. The memory 502 may also include high-speed random access memory and non-volatile memory, such as one or more disk storage devices or flash storage devices. In some embodiments, the non-transitory computer-readable storage medium in memory 502 is used to store at least one instruction, which is executed by the processor 501 to perform the method for evaluating the state of health of the battery according to some embodiments of the present disclosure.

In some embodiments, a computer-readable storage medium is provided. The storage medium stores a computer program. The computer program, when executed by the processor, causes the processor to perform the steps of the method for evaluating the state of health of the battery described in the above embodiments. For example, the computer-readable storage medium may be ROM, RAM, CD-ROM, tape, floppy disk, and optical data storage devices, etc.

It should be noted that the computer-readable storage medium mentioned in the embodiments of the present disclosure may be non-volatile, i.e., a non-transitory storage medium.

It should be understood that all or part of the steps of the above embodiments may be implemented using software, hardware, firmware, or any combination thereof. When implemented using software, it may be fully or partially implemented in the form of a computer program product. The computer program product includes one or more computer instructions. The computer instructions may be stored in the aforementioned computer-readable storage medium.

That is, in some embodiments, a computer program product including instructions is also provided. The instructions, when executed on a computer, cause the computer to perform the steps of the method for evaluating the state of health of the battery described above.

It should be understood that the term "at least one" refers to one or more, and "a plurality of' refers to two or more. In the description of the embodiments of the present disclosure, unless otherwise specified, "/" indicates an "or" relationship, for example, A/B can mean A or B; the term "and/or" herein is only a kind of association relationship describing related objects, indicating that there can be three kinds of relationships, for example, A and/or B can mean: A exists alone, A and B exist simultaneously, or B exists alone. In addition, to facilitate a clear description of the technical solutions of the embodiments of the present disclosure, terms such as "first" and "second" are used in the embodiments of the present disclosure to distinguish identical or similar items with essentially the same functions and effects. Those skilled in the art can understand that terms such as "first" and "second" do not limit the quantity or order of execution, and that terms such as "first" and "second" also do not necessarily mean being different.

It should be noted that the information (including but not limited to user device information, user personal information, etc.), data (including but not limited to data used for analysis, stored data, displayed data, etc.), and signals involved in the embodiments of the present disclosure are all authorized by the user or fully authorized by all parties. Moreover, the collection, use, and processing of relevant data need to comply with the relevant laws, regulations, and standards of the relevant countries and regions.

The above descriptions are the embodiments provided by the present disclosure and are not intended to limit the scope of the present disclosure. Any modifications, equivalent replacements, improvements, etc., made within the spirit and principles of the present disclosure should be included within the scope of protection of the present disclosure.

## Claims

1. A method for evaluating state of health of a battery, comprising:
acquiring target operating condition information of a target battery and a target cumulative charge-discharge capacity of the target battery under a target operating condition, wherein the target operating condition information comprises at least one of battery temperature, battery state of charge, or charging mode, wherein the charging mode comprises a fast charging mode and a slow charging mode;
determining a target battery health coefficient corresponding to the target operating condition information from battery health coefficients corresponding to a plurality of operating condition information intervals, wherein the battery health coefficient is configured to indicate a degree of influence of different operating condition information on state of health of a battery; and
determining a health degree of the target battery based on the target cumulative charge-discharge capacity and the target battery health coefficient, wherein the health degree is configured to indicate state of health of the target battery.

2. The method according to claim 1, wherein the plurality of operating condition information intervals are operating condition information intervals corresponding to a target chemical system characteristic, and the target chemical system characteristic is a chemical system characteristic of the target battery, wherein operating condition information intervals corresponding to different chemical system characteristics are different.

3. The method according to claim 2, wherein the chemical system characteristic comprises at least one of the following: electrode material, electrolyte material, or electrode sheet process parameters.

4. The method according to any one of claims 1 to 3, wherein the battery health coefficients corresponding to the plurality of operating condition information intervals are obtained by simulating an entire life cycle of a battery;
wherein a simulation process comprises:
acquiring a target temperature interval, a target state of charge interval, and a target charging mode, wherein the target temperature interval refers to a temperature interval causing battery life degradation, the target state of charge interval refers to a state of charge interval causing battery life degradation, and the target charging mode comprises a plurality of charging modes;
dividing the target temperature interval into a plurality of temperature sub-intervals and dividing the target state of charge interval into a plurality of state of charge sub-intervals;
obtaining a plurality of operating condition information intervals by combining the plurality of temperature sub-intervals, the plurality of state of charge sub-intervals, and the plurality of charging modes, wherein each of the plurality of operating condition information intervals comprises one temperature sub-interval, one state of charge sub-interval, and one charging mode;
determining, based on the plurality of operating condition information intervals and cumulative charge-discharge capacities respectively corresponding to the plurality of operating condition information intervals, the battery health coefficients respectively corresponding to the plurality of operating condition information intervals using a life-cycle simulation model.

5. The method according to claim 4, wherein said determining, based on the plurality of operating condition information intervals and cumulative charge-discharge capacities respectively corresponding to the plurality of operating condition information intervals, the battery health coefficients respectively corresponding to the plurality of operating condition information intervals using the life-cycle simulation model comprises:
determining, for each of the plurality of operating condition information intervals, battery health coefficients respectively corresponding to multiple operating condition data in the operating condition information interval using the life-cycle simulation model, wherein each of the multiple operating condition data indicates one temperature, one state of charge, and one charging mode; and
determining, based on the battery health coefficients respectively corresponding to the multiple operating condition data and a cumulative charge-discharge capacity corresponding to the operating condition information interval, a battery health coefficient corresponding to the operating condition information interval.

6. The method according to claim 4, wherein the target temperature interval, the target state of charge interval, and the target charging mode are respectively a temperature interval, a state of charge interval, and a charging mode corresponding to a target chemical system characteristic, wherein the target chemical system characteristic is a chemical system characteristic of the target battery, and temperature intervals, state of charge intervals, and charging modes corresponding to different chemical system characteristics are different.

7. An apparatus for evaluating state of health of a battery, comprising:
a battery information acquisition module, configured to acquire target operating condition information of a target battery and a target cumulative charge-discharge capacity of the target battery under a target operating condition, wherein the target operating condition information comprises at least one of battery temperature, battery state of charge, or charging mode, wherein the charging mode comprises a fast charging mode and a slow charging mode;
a battery health coefficient determination module, configured to determine a target battery health coefficient corresponding to the target operating condition information from battery health coefficients corresponding to a plurality of operating condition information intervals, wherein the battery health coefficient is configured to indicate a degree of influence of different operating condition information on state of health of a battery; and
a battery health degree determination module, configured to determine a health degree of the target battery based on the target cumulative charge-discharge capacity and the target battery health coefficient, wherein the health degree is configured to indicate state of health of the target battery.

8. The apparatus according to claim 7, wherein the plurality of operating condition information intervals are operating condition information intervals corresponding to a target chemical system characteristic, and the target chemical system characteristic is a chemical system characteristic of the target battery, wherein operating condition information intervals corresponding to different chemical system characteristics are different.

9. A vehicle, comprising a processor and a memory configured to store at least one computer program, wherein the at least one computer program, when loaded and executed by the processor, causes the processor to perform the method as defined in any one of claims 1 to 6.

10. A computer-readable storage medium storing at least one computer program, wherein the at least one computer program, when loaded and executed by a processor, causes the processor to perform the method as defined in any one of claims 1 to 6.
